Europäisches Patentamt

European Patent Office

Office européen des brevets

(11) Publication number: **0 465 229 B1**

# EUROPEAN PATENT SPECIFICATION

(45) Date of publication of patent specification: **28.12.94**   (51) Int. Cl.5: **F04B 43/04**, F04B 21/02, H01L 21/308

(21) Application number: **91306015.8**

(22) Date of filing: **02.07.91**

(54) Micropump and process for manufacturing a micropump.

(30) Priority: **02.07.90 JP 175060/90**
**06.07.90 JP 178708/90**
**06.07.90 JP 178709/90**
**06.07.90 JP 178710/90**
**06.07.90 JP 178713/90**
**21.09.90 JP 252265/90**
**17.09.90 JP 246527/90**
**12.10.90 JP 273635/90**

(43) Date of publication of application:
**08.01.92 Bulletin 92/02**

(45) Publication of the grant of the patent:
**28.12.94 Bulletin 94/52**

(84) Designated Contracting States:
**CH DE FR GB LI NL**

(56) References cited:
**EP-A- 0 392 978**
**US-A- 3 888 708**

**SENSOR AND ACTUATORS. vol. 15, no. 2, October 1, 1988, LAUSANNE CH pages 153 -157; H. T. VAN LINTEL: 'A PIEZOELECTRIC MICROPUMP BASED ON MICROMACHINING OFSILICON '**

(73) Proprietor: **SEIKO EPSON CORPORATION**
**4-1, Nishishinjuku 2-chome**
**Shinjuku-ku**
**Tokyo (JP)**

(72) Inventor: **Kamisuki, Shinichi**
**c/o Seiko Epson Corporation,**
**3-5, Owa 3-chome**
**Suwa-shi,**
**Nagano-ken (JP)**
Inventor: **Nose, Yasuto**
**c/o Seiko Epson Corporation,**
**3-5, Owa 3-chome**
**Suwa-shi,**
**Nagano-ken (JP)**
Inventor: **Shimizu, Nobuo**
**c/o Seiko Epson Corporation,**
**3-5, Owa 3-chome**
**Suwa-shi,**
**Nagano-ken (JP)**
Inventor: **Yotsuya, Shinichi**
**c/o Seiko Epson Corporation,**
**3-5, Owa 3-chome**
**Suwa-shi,**
**Nagano-ken (JP)**

PROCEEDINGS 8TH BIENNIAL MICROELEC-
TRONICS SYMPOSIUM June 12, 1989, WEST-
BOROUGH,MASSACHUSETTS, pages 91-94;
J.G: SMITS: 'PIEZOELECRIC MICROPUMP
WITH MICROVALVES'

(74) Representative: **Miller, Joseph et al**
**J. MILLER & CO.**
**34 Bedford Row,**
**Holborn**
**London WC1R 4JH (GB)**

**Description**

This invention concerns a micropump and a method of manufacturing a micropump, for use in fields such as medical analysis and treatment and for chemical analysis as a precision control device.

Micro-machining technology is currently the subject of research as a way to open up new, high level technologies. Some of the trends in this technology have been disclosed in the Japanese magazine "Nikkei Electronics", volume no. 480 (21st August, 1989), pages 125 to 155, in an article entitled "Silicon Micro-Machining Technology".

In this article, a discussion of micropump design is given on pages 135 to 139. A micropump permits minute and precise flow control and has the advantage of making medical and chemical analyses possible.

Moreover, the production of micro-mechanical devices, that fall within the category of the micropump mentioned above, is described in the latter half of the article mentioned above. That is, on pages 146 to 149 of the article, a production method that employs semiconductor etching technology (such as anisotropic etching etc.) for forming silicon into a complex three dimensional structure is described. On pages 150 to 152 of the article, substrate bonding technology, including an anodic bonding method for securing glass and silicon substrates etc. together for fabricating a variety of shapes, is also described.

A silicon pressure sensor is a device that was developed early on and has reached the practical level as a micro-mechanical device. However, the micropump, which is the most advanced device of the subsequent research, is currently at the trial production stage and is not yet available for practical use. Further, the production method for the micropump is still being researched. Consequently, it can be said that an established production method for the micropump does not yet exist.

There are a number of ways of driving a micropump, based on micro-machining technology. For instance, there are the piezoelectric method and the electrostatic method. Sensors & Actuators, Volume 15, No. 2, October 1988, Lausanne, Switzerland, pages 153-167 H.T VAN LINTEL: "A PIEZOELECTRIC MICROPUMP BASED ON MICROMACHINING OF SILICON" discloses a piezoelectric micropump. This article describes the design and realization of two pumps based on the micro-machining of silicon. The pumps, which are of the reciprocating displacement type, comprise one or two pump chambers, a thin glass pump membrane actuated by a piezoelectric disc and passive silicon check valves to direct the flow. Chambers, channels and valves are realized in a silicon wafer by wet chemical etching. The results of mechanical calculations and simulations show good agreement with the actual behaviour of the pumps. It is concluded that it is possible to design pumps having a specific yield and pressure dependence, and which are fail-safe (the flow is blocked while the pump is switched off).

The structure of a main micropump unit is basically the same, whether it is driven piezoelectrically or electrostatically. A silicon substrate is etched on both sides to form a diaphragm and a valve. After these steps are complete, the silicon substrate is sandwiched between glass substrates and a micropump with flow channels and valves is created by bonding the junctions using the anodic bonding method to form a single unit.

In the case of a micropump with this kind of structure, it is necessary to apply a pre-load to the valve in order to obtain a tight seal for the valve and to prevent leakage in a reverse direction. In the prior art, silicon dioxide is formed through thermal oxidation of the silicon substrate, and then areas other than an outer surface of the valve are removed by etching. The silicon dioxide level remaining as the outer valve surface is then used as a thin film layer for applying the pre-load (the pre-load layer).

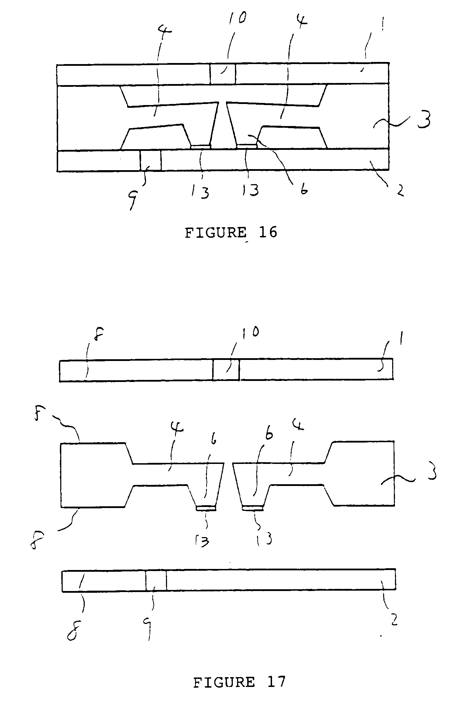

The structure of a prior art diaphragm valve for a micropump is shown in figure 16, which is a cross-section through the diaphragm valve. A diaphragm 4 is formed by etching a silicon wafer 3 with a 30% KOH solution that has been heated 60°C. The silicon wafer 3 is then sandwiched between a lower glass substrate 2 with an entry port 9 therein and an upper glass substrate 1 with an exit port 10 therein using anodic bonding, thereby forming the diaphragm valve.

With this structure, in order to prevent reverse flow, ie. flow from the exit port 10 in the substrate 1 to the entry port 9 in the substrate 2, when back pressure is applied to the diaphragm valve, it is necessary to apply a pre-load to the diaphragm 4 to enhance its seal.

The prior art production process is represented in figure 17. The diaphragm 4 is formed using photolithography to create holes and varying surface levels in each side of the silicon wafer 3. At this time, a glass bonding surface 8 of the silicon wafer 3 and a valve member 6 of the silicon wafer 3 are in a relationship in which they are at the same surface level. If the glass substrate 2 and the glass substrate 1 were used in this condition, that is if anodic bonding were used to sandwich the silicon wafer 3 between the two substrates, a pre-load could not be applied to the diaphragm 4. As a consequence, a production process that allows a pre-load to be applied to the diaphragm 4 is used. In this process, a pre-load spacer 13 is formed on the valve member 6 of the silicon wafer 3 as the pre-load layer. After that, the glass

3

substrate 2 and the glass substrate 1 are attached using anodic bonding to create the sandwich structure.

The pre-load spacer 13 is fabricated by stacking a flat mask with holes in it onto the silicon wafer 3 and mask sputtering a silicon oxide layer of 1 $\mu$m thickness on the surface of the valve member 6. The sputtering takes place only where there are holes and where contact is to be made with glass substrate 2. This is how the pre-load spacer is formed and how a pre-load is applied to the diaphragm 4.

Anisotropic etching, etching in which the etching rate varies according to the orientation of the crystal plane, has been used with an alkaline solution as mentioned above for the etching of silicon substrates. For example, in the case of a (100) silicon substrate, the etching rate of a (111) surface is extremely slow compared to the etching rate of a (100) surface. Etching can produced (100) and (111) surfaces. As a result, a variety of elements have been designed, which take advantage of this characteristic. In order to provide higher level functions using these elements, production in more complicated configurations is being considered.

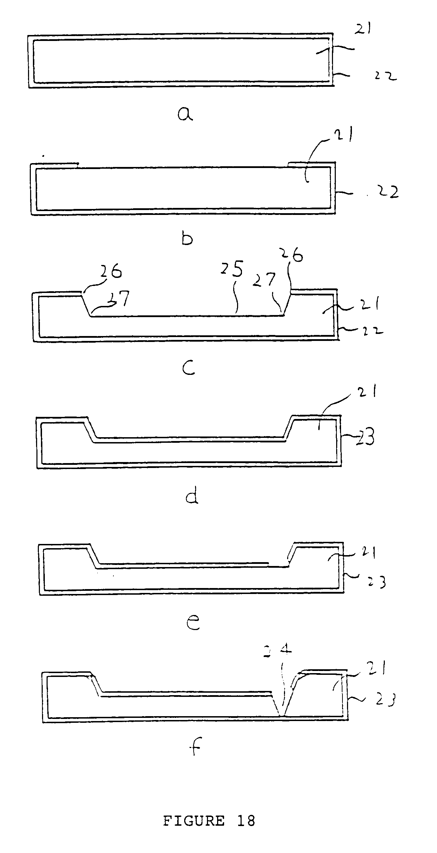

An example of a device that sprays out minute quantities of liquid in precise amounts is a prior art ink jet print head, whose production process is illustrated in figure 18. This constitutes one type of micropump. A thermal oxide layer 22 (figure 18(a)) is formed on a silicon substrate 21. The aforementioned thermal oxide layer 22 is patterned for ink flow channels using photolithography and hydrofluoric acid etching (figure 18(b)). An alkaline solution is used to etch the silicon substrate 21 to the specified depth and form an ink flow channel 25 (figure 18(c)). Thermal oxidation is used to form a thermal oxide layer 23 over the entire surface of the flow channel 25 (figure 18(d)). The thermal oxide layer 23 is then patterned in the same manner for forming a spray nozzle (figure 18(e)). An alkaline solution is then used to etch the spray nozzle 24 until it is thoroughly open (figure 18(f)).

However, if this prior art process described above were used in the valve of figure 16, or the valve of the micropump of the above sensors and actuators article, the silicon dioxide layer providing the pre-load layer would be composed of an inorganic material, which becomes very hard and lacks flexibility. As a result, because of the shape of the valve and because of warping, there would be unstable contact of the pre-load layer on the glass substrate surface, at times creating a poor sealing valve and causing reverse flow leakage.

In addition, there are restrictions on the thickness of the silicon dioxide layer providing the pre-load layer. In assembly (anodic bonding) with the glass substrate, if the silicon dioxide layer is thin, the valve member will bond with the glass surface. Therefore, a certain minimum thickness (1.0 $\mu$m) is required, and this would cause problems in fine flow control using the pre-loading of the valve.

Furthermore, if the valve were not used for a long period of time, the silicon dioxide layer providing the pre-load layer would remain in contact with the glass for a long period of time, creating a sticking phenomenon under certain conditions and preventing movement of the valve member during actual use. As a result, the margin of tolerance for the valve function is low and the production yield poor.

Moreover, the diaphragm of the prior art micropump is fabricated in the centre of the silicon wafer in the direction of its thickness. Therefore, a large amount of etching is required in the anistropic etching, and this easily distorts the shape of the valve and invites the danger of a reduction in the degree of sealing. As a result, micropump photo-masks have to be designed with consideration given to the possibility of deforming the valve, and this adds restrictions to the design of the micropump.

Using the prior art technology shown in figures 16 and 17, forming the pre-load spacer 13 on the entire surface of the valve member 6 is the only way of applying a pre-load to the diaphragm. However, a silicon wafer with a (100) surface orientation will have a different etching rate depending on the crystal surface. This means that the pre-load spacer 13 of the valve member 6 would not be circular in shape and hence it would not have uniform contact with the glass substrate, which causes the problem of reverse flow.

Also, because the contact surface is large, the pre-load per unit area would be small and the liquid flow would tend to reverse. Further, if the contact surface is large, it increases the probability that foreign matter will enter in between the pre-load spacer 13 and the glass substrates 1 and 2, again causing reverse flow.

In the case of mask sputtering, the mask edge itself would get in the way, making sputtering difficult by causing more thickness in the centre. When the valve member 6 is off centre, deformation occurs and a gap appears between the pre-load spacer 13 and the glass substrate 2. As a result, the amount of flow from the exit port 10 will vary.

The reason for this is that the formation of the diaphragm 4 takes place under the time control of the etching and the etching rate varies, making it difficult to produce a constant thickness for the diaphragm 4. As a result, the thickness of the diaphragm varies. There are also variations in the amount of diaphragm deformation from its drive source, and this results in the problem of variation in the amount of flow.

In the case of the prior art technologies described with reference to figure 18 above, the following problems exist: in the step of figure 18(e), the ink flow channel 25 has already been formed in the silicon

4

EP 0 465 229 B1

wafer 21. The depth of the ink channel is about 100 $\mu$m to 200 $\mu$m. It is very difficult to apply photo-resist (not illustrated) uniformly to the silicon wafer 21 when it has such deep channels. In particular, because the photo-resist layer on a protruding section 26 is very thin, the base thermal oxide layer is etched slightly when hydrofluoric acid etching takes place. In the following silicon etch, the upper part of the ink flow channel 25 is etched, creating the problem of not achieving the specified shape.

Conversely, in a depression 27, the photo-resist layer becomes very thick and the exposure of the mask pattern is carried out at a distance from 100 $\mu$m to 200 $\mu$m. This results in very poor pattern accuracy, which leads to the spray nozzle 24 having poor pattern accuracy. This problem does not appear only in the case of the example being discussed here. It is a problem that appears when producing any micropump or pressure sensor by etching the silicon to depths of a few hundred $\mu$m using alkaline anisotropic etching.

It is an object of the present invention, at least in its preferred form, to resolve one or some of the problems described above.

According to a first aspect of the present invention, there is provided a micropump comprising a silicon substrate, which is sandwiched between glass substrates and which is formed with a diaphragm and a valve, the valve including a valve membrane and a valve member for controlling fluid flow through a though-hole in the valve membrane, the valve member engaging one of the glass substrates, characterised in that the diaphragm and the valve membrane are disposed closer to said one glass substrate engaged by the valve member than to the other of the glass substrates.

According to a further aspect of the present invention, there is provided a method of manufacturing a micropump comprising the steps of forming on one side of a silicon substrate a mask pattern of an etch resistant material so as to leave an etching pattern for providing a diaphragm and a valve membrane, forming on the other side of the silicon substrate a mask pattern of an etch resistant material so as to leave an etching pattern for providing a through-hole, forming on said other side a mask pattern of an etch resistant material so as to leave an etching pattern for providing said diaphragm, said valve membrane and a valve member, etching the silicon substrate by anisotropic etching to form the diaphragm, the valve membrane, the valve member and the through-hole, and sandwiching the silicon substrate between glass substates, characterised in that the etching is effected such that the diaphragm and the valve membrane are closer to said other side than to said one side of the silicon substrate.

A further production method for the micropump according to the present invention is characterised by fabricating on one side of a (100) oriented silicon wafer an etching mask that corresponds to the diaphragm and the valve membrane, by fabricating on an opposite side of the silicon wafer an etching mask that corresponds to the through-hole, by etching both sides of the silicon wafer a designated amount using wet anisotropic etching, by fabricating an etching mask that corresponds to the valve on the opposite side of the silicon wafer and by etching both sides of the silicon wafer a specified amount using wet anisotropic etching to fabricate the diaphragm, valve and valve membrane to the desired shape.

Another method of producing the micropump according to the present invention is characterised by fabricating an etching mask that corresponds to the diaphragm and the valve membrane on one side of a (100) oriented silicon wafer, by fabricating a depression of a desired depth using wet anisotropic etching on the surface of said one side of the silicon wafer, by masking the surface of said one side of the silicon wafer with a silicon dioxide layer and fabricating an etching mask that corresponds to the through-holes on the opposite side of the silicon wafer, by fabricating depressions to the desired depth on the other side of the silicon wafer using wet anisotropic etching, which depressions will become the through-holes, and by fabricating an etching mask that corresponds to the valve on the opposite side of the silicon wafer, and by fabricating the diaphragm, valve, valve membrane and through-hole by etching the opposite side of the silicon wafer using wet anisotropic etching.

According to a still further aspect of the present invention, there is provided a micropump having a diaphragm, a flow channel, a valve and through-holes formed in a silicon substrate through wet anisotropic etching, the substrate being sandwiched between glass substrates and the valve having formed thereon a high polymer layer providing a pre-load layer, which contacts an adjacent one of the glass substrates.

Preferably, the high polymer layer comprises a heat resistant polymer such as a polyimide or a polyamide.

By providing the high polymer layer as a pre-load layer for the valve of the micropump, variation in the shape and bow of the valve due to contact between the valve and the glass substrate will be absorbed. In the prior art, sealing of the valve was occasionally insufficient due to the phenomenon of partial contact in the inorganic layer. However, in the present instance, the flexibility of the high polymer layer allows the absorption of some of this partial contact. And because the area all around the valve can come into contact with the surface of the glass substrate, a tight valve seal is insured which enhances manufacturing

5

tolerances.

According to a still further aspect of the present invention, there is provided a micropump having a diaphragm, a flow channel, a valve and through-holes formed in a silicon substrate through wet anisotropic etching, the silicon substrate being sandwiched between glass substrates and the valve having formed thereon a nitride layer providing a pre-load layer, which contacts an adjacent one of the glass substrates.

For example, the nitride layer may comprise TiN, AlN and TaN.

By employing a nitride pre-load layer, there will be no bonding with the glass substrate when anodic bonding takes place even if the pre-load layer is only a thin film, and hence the pre-load strength can be freely controlled.

In the prior art, wherein the pre-load layer is formed from silicon dioxide, it is natural for sticking to take place under certain conditions of lengthy storage. However, in the present instance, because of the nitride substance used in the pre-load layer, the degree of surface activity is low and so there is no bonding with the glass substrate over time. This eliminates any reduction in micropump efficiency after a long period of storage.

According to a still further aspect of the present invention, there is provided a micropump having a diaphragm, a flow channel, a valve and through-holes formed in a silicon substrate through wet anisotropic etching, the silicon substrate being sandwiched between glass substrates and the valve having a circular protrusion, which contacts an adjacent one of the glass substrates.

Preferably, the protrusion has a width of 500 $\mu$m or less and a height of 5 $\mu$m or less. The protrusion may be made of a high polymer polyimide, a polyamide or silicon dioxide.

In the prior art, the etching rate of a single crystal silicon wafer varies depending on the crystal plane, making the formation of a circular shape difficult and the fabrication of a circular protrusion impossible. As a result, the valve may make uneven contact with the glass substrate, causing a reverse flow. In the present instance, when the height of the circular protrusion is 5 $\mu$m or less, there is less deformation due to etching and the protrusion contacts the glass substrate evenly. As a result, reverse flow due to back pressure is prevented and the leakage resistance of the valve is enhanced. No problems are created if the dimensions of the valve are larger than the circular protrusion and there are no problems with deep etching. Further, if the circular protrusion has a width of 500 $\mu$m or less, the leakage resistance of the valve against back pressure is obtained by the pre-load concentration on the circular protrusion.

Also, in the case where the contact surface is large, there is a higher probability that foreign matter will enter between the valve and the glass substrate. However, in the present instance, if the circular protrusion has a contact span of 500 $\mu$m or less, such probability is reduced, which prevents reverse flow when back pressure is applied.

The present invention thus provides a micropump in which a highly accurate pre-load layer can be obtained. The valve shape and structure avoids inconvenient phenomena such as sticking between the pre-load layer and the surface of the glass substrate, and hence provides an enhanced freedom of design.

In addition, the invention provides a further method for manufacturing the aforementioned micropump designed to control the thickness of the diaphragm to constant dimensions.

According to this further aspect of the invention, a silicon wafer is formed with a diaphragm, a flow channel, a valve and a through-hole fabricated from the same material as a single unit, and the method is characterised by fabricating the diaphragm by etching, by forming a depression that will become a through opening having a depth that is exactly the same as the thickness of the diaphragm and by forming a first etching end point detection pattern on one side of the silicon wafer by means of etching.

This method is further characterised by fabricating a second end point detection pattern either on the side of the silicon wafer bearing the first end point detection pattern or on both sides of the silicon wafer such that the second end point detection pattern overlaps part or all of the first end point detection pattern, and by detecting when the overlapping portions of the first and second end point detection patterns have opened, and then ending the etching.

The method of detection may be optical, physical, electrical, visual or some other method.

Using the method just described, the thickness of the diaphragm can be accurately determined. Amongst the possible methods of detection, one possibility is to sense the transmission of light optically when the detection pattern is penetrated. Another possibility is to detect a change in the position of the silicon wafer when it is cut through, for example by physical means, by electrical means or by visual means.

According to yet another aspect of the present invention there is provided a method of processing a silicon wafer by using an alkaline etching solution for forming depressions and through-holes in the silicon wafer. A silicon dioxide film with different thicknesses is used for the etching mask. During the etching, the areas of the silicon dioxide film that are relatively thin will gradually disappear first. Then by continuing to etch the silicon beneath the silicon dioxide film that has disappeared, structures with a variety of depths can be formed in the silicon substrate.

One way of forming the silicon dioxide film with areas of different thicknesses is to repeat silicon substrate thermal oxidation and the patterning process for the thermal oxide film obtained from this thermal oxidation a number of times. Or, a thermal oxide film may be formed on the silicon substrate and a patterning process that includes half etching of the thermal oxide film obtained from the thermal oxidation may be effected either once or a number of times.

The invention is described further, by way of example, with reference to the accompanying drawings in which:

Figures 1(a) to 1(i) are cross-sectional views showing production steps in a process for manufacturing a first micropump according to the present invention;

Figure 2 is a cross-sectional view of the first micropump taken along the line A-A in figure 3;

Figure 3 is a top plan view of the first micropump;

Figures 4(a) to 4(k) are cross-sectional views showing production steps in a further process for manufacturing the first micropump;

Figures 5(a) to 5(l) are cross-sectional views showing production steps in a still further process for manufacturing the first micropump;

Figures 6(a) to 6(d) are cross-sectional views showing production steps in a process for manufacturing a second micropump according to the present invention;

Figures 7(a) to 7(d) are cross-sectional views showing production steps in a process for manufacturing a third micropump according to the present invention;

Figures 8(a) and 8(b) are, respectively, a cross-sectional view of a diaphragm valve for use with a fourth micropump according to the present invention, and an exploded cross-sectional view of the components of the diaphragm valve for explaining the process for manufacturing the diaphragm valve;

Figures 9(a) and 9(b) are, respectively, a cross-sectional view of a further diaphragm valve for use with the fourth micropump, and an exploded cross-sectional view of the components of the further diaphragm valve for explaining the process for manufacturing the further diaphragm valve;

Figures 10(a) and 10(b) are, respectively, a cross-sectional view of another diaphragm valve, and an exploded cross-sectional view of the components of said another diaphragm valve for explaining the process for manufacturing said another diaphragm valve;

Figures 11(a) and 11(b) are views showing the end of a production step for a micropump according to the present invention;

Figures 12(a) to 12(c) are cross-sectional views showing production steps for a silicon substrate for a micropump according to the present invention;

Figures 13(a) to 13(c) are diagrammatic views representing alternative detection methods for use in a process for manufacturing a micropump according to the present invention;

Figures 14(a) to 14(f) are cross-sectional views showing production steps in a process for manufacturing a silicon substrate for use in a micropump according to the present invention;

Figures 15(a) to 15(d) are cross-sectional views showing production steps in a process for manufacturing a further silicon substrate for use in a micropump according to the present invention;

Figure 16 is a cross-sectional view of a diaphragm valve for a conventional micropump;

Figure 17 is an exploded cross-sectional view of the components of the diaphragm valve of figure 16 for explaining the process for manufacturing the conventional diaphragm valve; and

Figures 18(a) to 18(f) are cross-sectional views showing production steps in a process for manufacturing a conventional ink jet print head.

### Embodiment 1

A diaphragm and valves for use in a micropump according to a first embodiment of the invention will now be described. Also, a number of variations, in which the valves are unevenly distributed in the direction of the thickness of a silicon substrate, and corresponding processes for producing the first embodiment will be described.

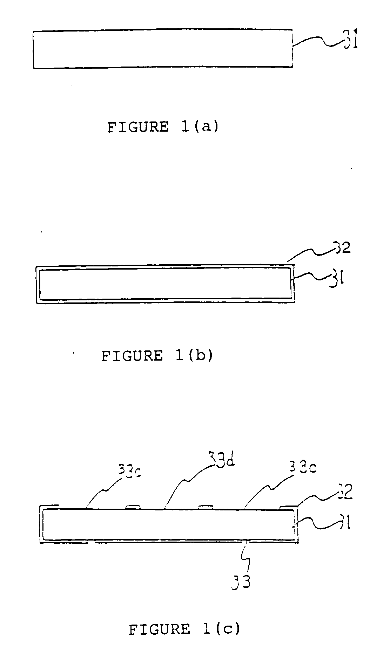

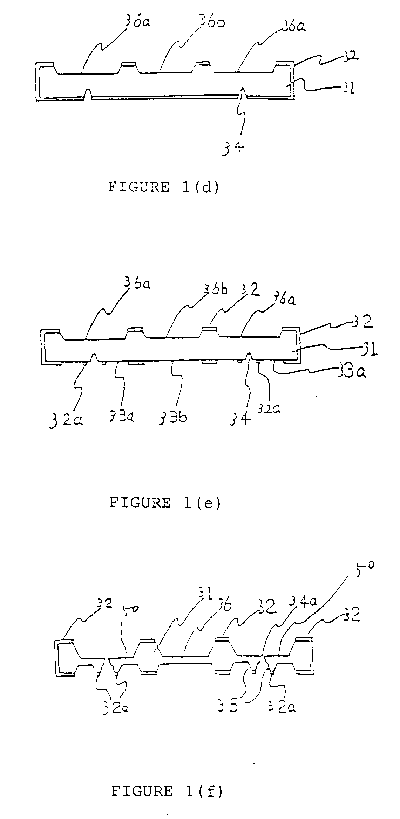

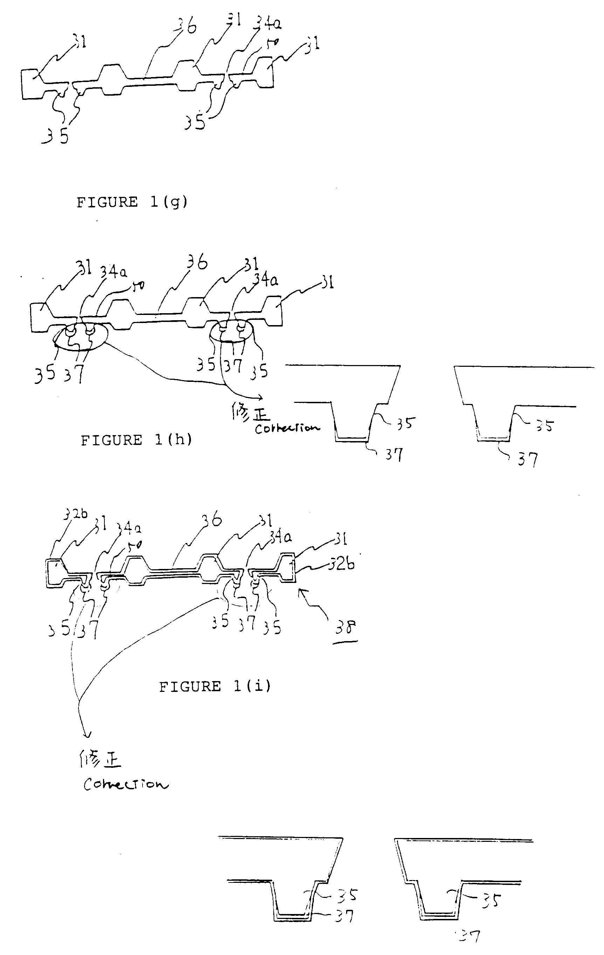

Referring initially to figure 1, figures 1(a) to 1(i) are cross-sectional views showing one embodiment of a thin film substrate production method for producing the body components of the first micropump according to the invention. Each production step will now be described in sequence referring to figures 1(a) to 1(i).

Firstly, as shown in figure 1(a), after polishing both sides of a silicon wafer, which has a (100) surface orientation, and washing the wafer, a silicon wafer 31 with a thickness of 280 $\mu$m is produced. Next, as indicated in figure 1(b), a 1.0 $\mu$m oxide film 32 (silicon dioxide film) is formed over the entire surface of the silicon wafer 31 using thermal oxidation. Following this, resist patterning of the oxide film 32 on both sides of the silicon wafer takes place and hydrofluoric acid etching is used to remove the pattern portion of the oxidised film from the silicon wafer, as shown in figure 1(c). On one side of the silicon wafer, etching mask patterns 33d and 33c, which correspond to a diaphragm and a valve membrane of the micropump, are formed. On an opposite side of the silicon wafer, a mask pattern 33, which corresponds to through-holes of the micropump, is formed.

Next, both sides of the silicon wafer 31 undergo a first wet anisotropic etching to form a depression 36b to a depth of 60 $\mu$m for the diaphragm, a depression 36a for the valve membrane and a non-through-hole 34 (see figure 1(d)). The etching takes place in a potassium hydroxide 30% by weight aqueous solution at 80°C. In order to etch the silicon wafer 31 accurately to a depth of 60 $\mu$m, the temperature of the etching solution is maintained and the solution is stirred.

As indicated in figure 1(e), resist patterning is applied to the oxide film 32 on the side of the wafer 31 including the hole 34, and hydrofluoric etching is used to remove the pattern portion of the oxide film 32. This produces oxide film 32a and mask patterns 33b and 33a for the formation of a valve member and the diaphragm and the valve membrane.

The silicon wafer 31 then undergoes a second wet anisotropic etching in the same manner as the first wet anisotropic etching to form further depressions to a depth of 80 $\mu$m opposite the first depressions 36b and 36a, as indicated in figure 1(f). Now, the depth of the diaphragm depression 36b and of the valve membrane depression 36a is 140 $\mu$m due to the second wet anisotropic etching. As a result, a diaphragm 36 and a valve membrane 50 are produced, together with a valve member 35 which are offset towards the valve side of the wafer, as shown. The depth of the anisotropic etching for the valve 35 is 80 $\mu$m, allowing the deformation of the valve by etching to be reduced and promoting better sealing of the valve.

After this, a hydrofluoric acid solution is used to remove the oxide films 32 and 32a (see figure 1(g)).

Next, as shown in figure 1(h), in order to form a pre-load layer 37 to a thickness of 1.0 $\mu$m on the valve 35, mask sputtering of silicon dioxide takes place. This is to prevent the valve 35 from making contact with a glass substrate in anodic bonding steps of a subsequent assembly phase.

After this, thermal oxidation takes place to form an oxidation layer 32b to a thickness of 0.13 $\mu$m over the entire surface of the silicon wafer 31 as shown in figure 1(i). The oxidation of the entire surface of the wafer 31 is effected in order to allow fluids to flow easily and to improve the anti-corrosive properties of the surface of the wafer when the fluids contain chemicals. The process is thus completed and generates a silicon substrate 38, which provides the body of the micropump and in which the 1 $\mu$m thick pre-load layer 37 is left on the valve 35.

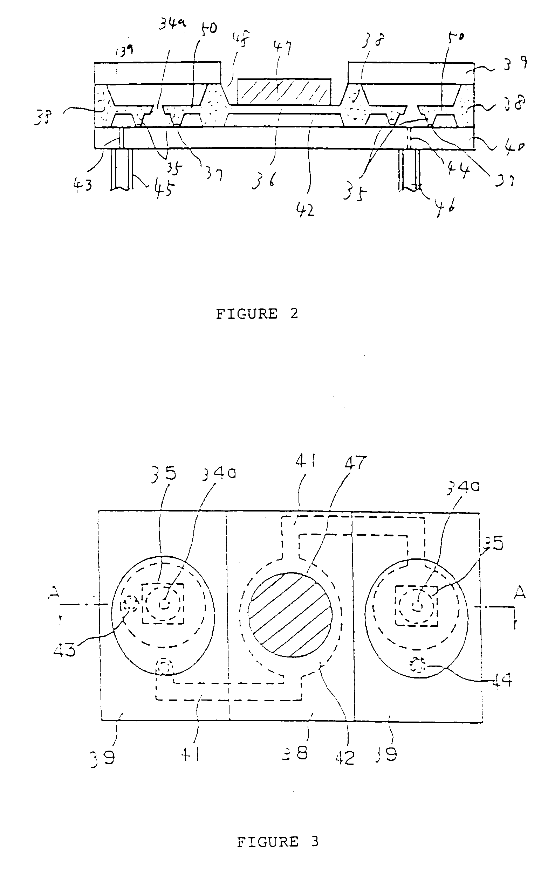

Figures 2 and 3 show the first embodiment of the micropump including the silicon substrate 38, which is shown without the thin oxide oxide layer 32b. As shown, the silicon substrate 38, including the diaphragm 36 and the valve 35, is attached by anodic bonding at specified locations to a lower glass substrate 40, which has an electrode not shown in the drawing (refer to the documentation mentioned above).

An upper glass substrate 39, which also has an electrode not shown in the drawing on its upper surface, is bonded in the same manner to form a flow channel 41 and a pressure chamber 42 connected to the flow channel 41. The upper glass substrate 39 and the lower glass substrate 40 both employ 1 mm thick borosilicate glass. Holes that will become a fluid outlet port 43 and a fluid spray port 44 are fabricated in the lower glass substrate 40 in advance. Since the oxide layer 32b is a thin layer having a thickness of 0.13 $\mu$m, anodic bonding is made possible. However, because the pre-load layer 37 has a thickness of 1.0 mm, it will not undergo anodic bonding.

After this, a supply tube 45 is connected below the supply port 43 and an outlet tube 46 is connected below the outlet port 44.

Finally, a piezoelectric element plate 47 is attached to the upper portion of the diaphragm 36, and the micropump is completed by providing electrical wiring (not illustrated) for driving the piezoelectric device and by providing tubing (also not illustrated) for connection to the supply port 45 and the outlet port 46.

The micropump produced by the foregoing process exhibits little deformity in its shape and maintains the intended design shape. In addition, only a little deformity of the valve 35 is obtained through the anisotropic etching.

Further, when a drive current was passed through the piezoelectric device and the micropump was used for supplying a liquid such as water, an output volume about the same as that required was obtained. This was due to the fact that there was little deformation of the etched flow channel 41, the valve 35 and the pressure chamber 42. The values obtained were close to those specified because the amount of anisotropic etching of the side of the silicon substrate 38 with the channels, valves and pressure chamber was limited.

An examination of water leakage (tightness of pump seal) was undertaken by stopping driving the piezoelectric device in the condition indicated above and applying the designated water pressure from the pump supply port. Absolutely no water leakage occurred. An examination of the existence or otherwise of reverse flow of water was also carried out by applying the designated water pressure at the pump outlet port. Again, there was absolutely no reverse flow. With reference to the tightness of the seal and the restriction of a reverse flow, there is a reduction in the amount of anisotropic etching on the side of the substrate 38 with the valve 35 because the diaphragm 36 is offset towards the valve side of the substrate 38 and in consequence there is almost no deformation or insufficency of the valve 35.

Next, an examination of the bubble removal condition of the micropump was undertaken. The method used was to apply more than the designated water pressure at the supply port 45 and then to observe the formation of bubbles in this condition. There were very good bubble removal characteristics. There was no case in which bubbles applied to the valve or to the through-hole could not be eliminated.

The embodiment of micropump described above employs a piezoelectric device as a means of driving the diaphragm. However, the production process according to the invention is not limited to micropumps which have such a structure. It goes without saying that this embodiment is applicable to micropumps of a different structure and to other similar flow control devices.

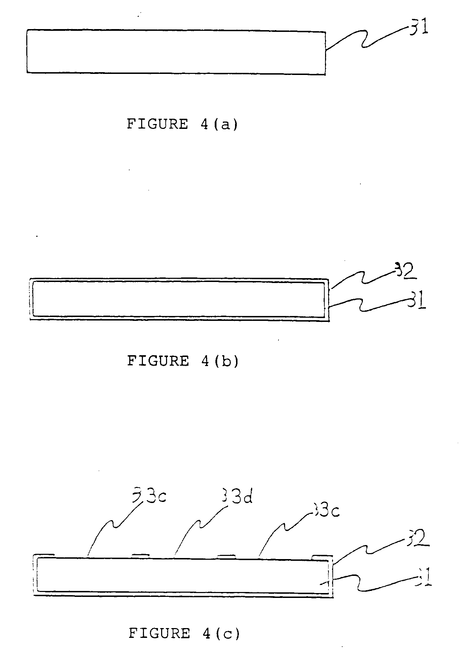

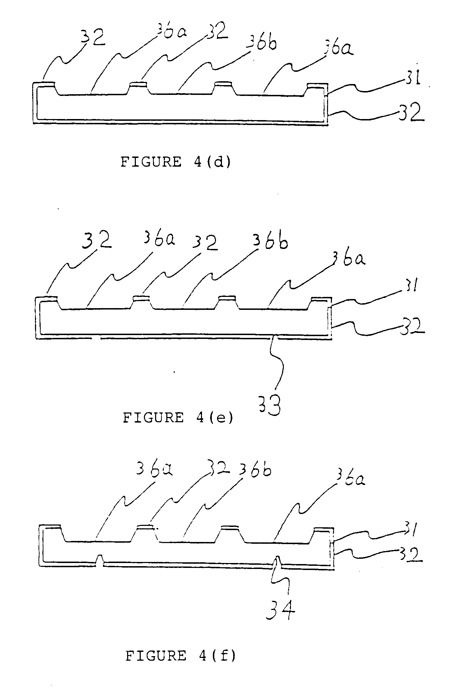

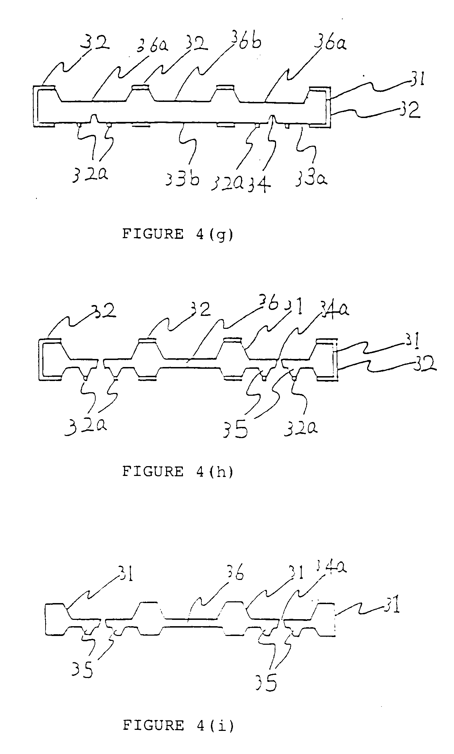

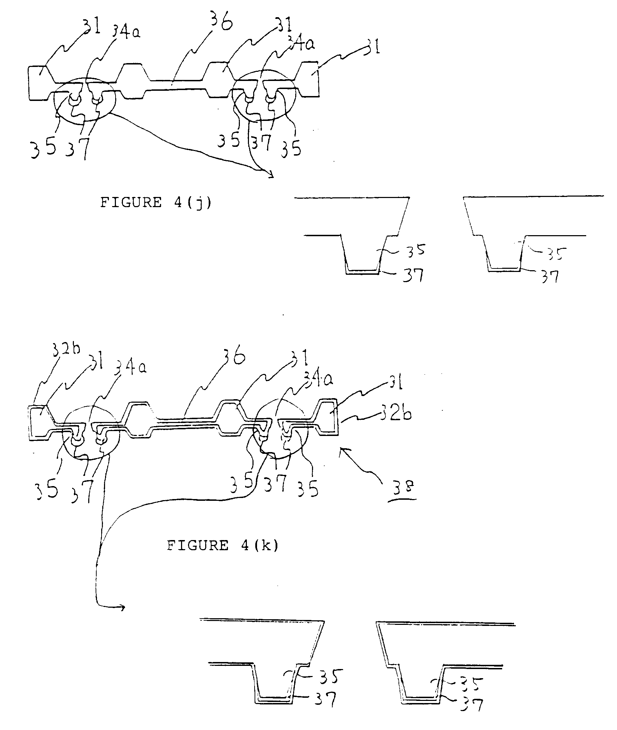

Figure 4 shows another process for forming a silicon substrate for a micropump according to the invention. The production steps of the process will be described in sequence with reference to figures 4(a) to 4(k). Parts which are the same as those shown in figures 1 to 3 are designated by the same reference numerals and will not be fully described.

Firstly, after both sides of a (100) surface orientation wafer has been polished and the wafer has been washed, a silicon wafer 31, which is 280 $\mu$m thick, is formed as shown in figure 4(a). A 1.0 $\mu$m oxide layer (silicon dioxide layer) 32 is formed over the entire surface of the silicon wafer 31 using thermal oxidation, as illustrated in figure 4(b).

Next, resist patterning of the oxide layer 32 is effected on both sides of the wafer 31 and the oxide layer of the pattern area is removed with hydrofluoric acid, as shown in figure 4(c), to form mask patterns 33d and 33c, which correspond to the diaphragm and the valve membrane, on one side of the silicon wafer 31.

Next, a first wet anisotropic etching takes place, forming a diaphragm depression 36b and a valve membrane depression 36a, which each have a depth of 60 $\mu$m, as shown in figure 4(d). The etching takes place with a potassium hydroxide 30% by weight aqueous solution at 80°C. In order to etch the silicon wafer 31 accurately to a depth of 60 $\mu$m, the temperature of the etching solution is maintained and the solution is stirred.

Following this, resist patterning of the oxide layer 32 on the opposite side of the silicon wafer 31 is effected, and the oxide layer 32 of the pattern area is removed using hydrofluoric acid etching to form a mask pattern 33, which corresponds to the through-holes, as shown in figure 4(e).

A second wet anisotropic etching of the silicon wafer 31 is effected in a similar manner to the first wet anisotropic etching to form a non-through-hole 34 to a depth of 60 $\mu$m on the opposite side of the silicon wafer 31, as indicated in figure 4(f). At this time, the diaphragm depression 36b and the valve membrane depression 36a each have a depth of 120 $\mu$m.

The opposite side of the silicon wafer 31 once again undergoes resist patterning, and the oxide layer 32 in the patterned area is removed using hydrofluoric etching leaving oxide layers 32a. This forms mask patterns 33b and 33a, as shown in figure 4(g), which correspond to the diaphragm and the valve.

Further anisotropic etching is effected to form the diaphragm 36 and the valve 35 at a depth of 50 $\mu$m on the opposite side of the silicon wafer 31, as shown in figure 4(h). At this time, the diaphragm depression 36b and the valve membrane depression 36a reach a depth of 170 $\mu$m, and the through-hole 34a is formed in the silicon wafer 31.

In this way, since the diaphragm 36 is unevenly distributed to the side of the silicon substrate in which the valve 35 is formed, the anisotropic etching for forming the valve 35 is only 50 $\mu$m deep. As a result, there is absolutely no deformation or deficiency of the valve 35, and an improvement in the sealing performance of the valve is possible. After this, the oxide layers 32 and 32a are removed with a hydrofluoric acid solution, as shown in figure 4(i).

Next, silicon dioxide mask sputtering is effected in order to form a 1 $\mu$m thick pre-load layer 37 on the valve 35 as shown in figure 4(j). This is to prevent the valve 35 from bonding with the glass in the anodic bonding step of the subsequent assembly phase.

After this, thermal oxidation is effected to form over the entire silicon wafer 31 a 0.13 $\mu$m thick oxidation layer 32b as shown in figure 4(k). This oxidation of the entire surface of the wafer is effected in order to allow fluids to flow easily and to improve the anti-corrosive properties of the surface of the wafer when the fluids employ chemicals. As shown in figure 4(k), the process for forming the silicon substrate 38, which is used for the body of the micropump and in which the 1 $\mu$m thick pre-load layer 37 is left on the valve 35, is thus completed.

The silicon substrate 38 produced by this process is assembled in a micropump in the same manner as described with reference to figures 2 and 3. Therefore, a further description of the assembly will be omitted.

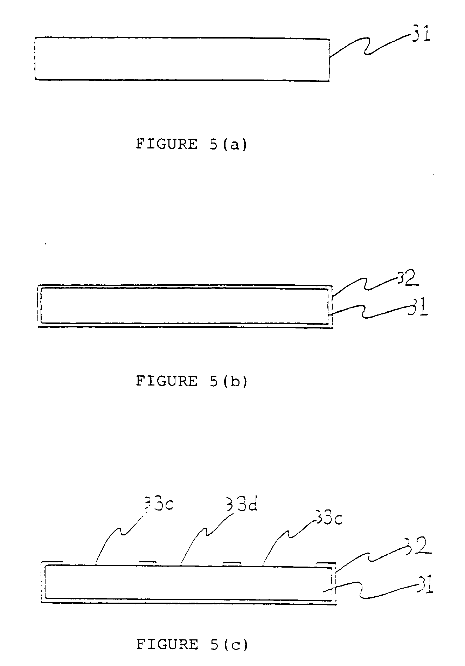

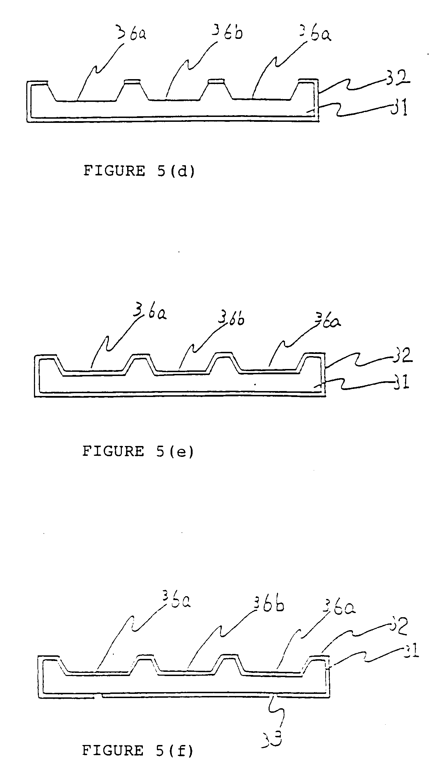

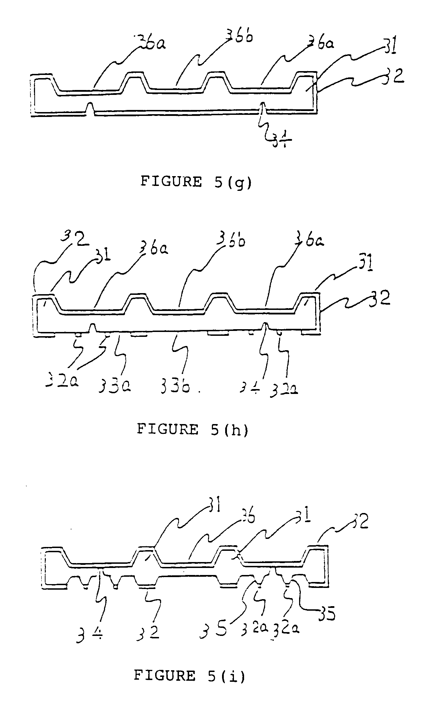

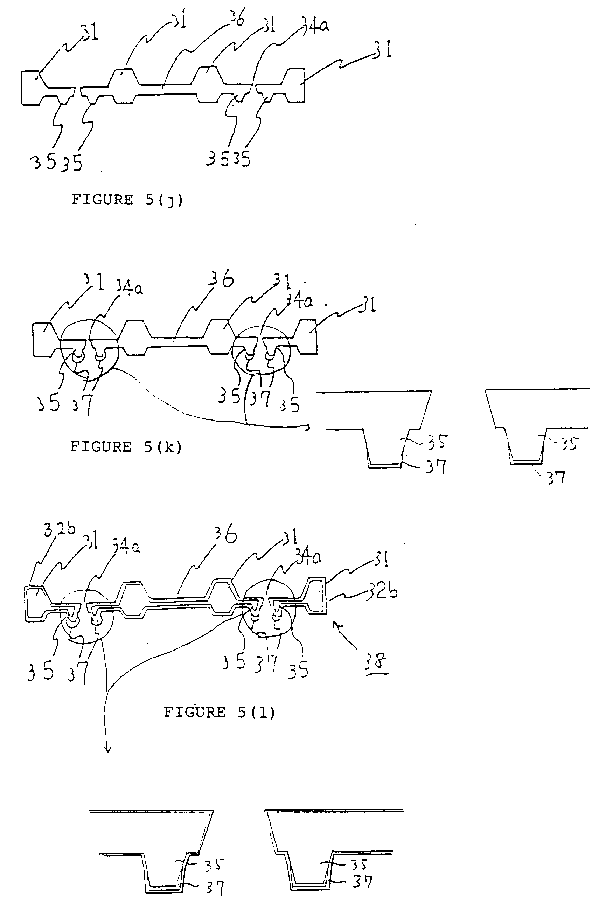

Figure 5 shows a further process for producing the silicon substrate for forming the body of the micropump. The production steps of this process will be described in sequence with reference to figures 5-(a) to 5(l).

Firstly, after both sides of a (100) surface orientation wafer have been polished, the wafer is washed. This forms a silicon wafer 31, which is 280 $\mu$m thick. As shown in figure 5(a). A 1.0 $\mu$m oxide layer (silicon dioxide layer) 32 is formed over the entire surface of the silicon wafer 31 using thermal oxidation, as indicated in figure 5(b).

Next, resist patterning of the oxide layer 32 is effected on one side of the wafer 31, and the oxide layer of the pattern area is removed with hydrofluoric acid. Mask patterns 33d and 33c, which correpond to the diaphragm and the valve membrane are thus formed on one side of the silicon wafer 31 as shown in figure 5(c).

Next, a first wet anisotropic etching takes place, forming a diaphragm depression 36b and a valve membrane depression 36a, each having a depth of 190 $\mu$m, as shown in figure 5(d). The etching takes place with a potassium hydroxide 30% by weight aqueous solution at 80° C. In order to etch the silicon wafer 31 accurately to a depth of 190 $\mu$m the temperature of the etching solution is maintained and the solution is stirred.

After this, the silicon wafer 31 is again fully covered with the oxide layer 32, as shown in figure 5(e), through thermal oxidation. In this case, since it is sufficient to cover the etched surface of the diaphragm depression 36b and the valve membrane depression 36a only, it is also sufficient to form the silicon dioxide layer 32 through sputtering. Resist patterning of the oxide layer 32 on the opposite side of the silicon wafer 31 is then effected, and the oxide layer 32 of the pattern portion is removed using hydrofluoric acid etching. This forms a mask pattern 33, which corresponds to the through-holes, as shown in figure 5(f).

A second wet anisotropic etching of the silicon wafer 31 is now effected, in a similar manner to the first wet anisotropic etching, to form a non-through-hole 34 to a depth of 60 $\mu$m. This hole is formed on the opposite side of the silicon wafer 31 as indicated in figure 5(g). In addition, this opposite side of the silicon wafer 31 once again undergoes resist patterning and the oxide layer 32 of the patterned portion is removed using hydrofluoric acid etching. This forms mask patterns 33b and 33a, which correspond to the diaphragm and the valve, and leaves the oxide layer 32a as shown in figure 5(h).

Anisotropic etching takes place once again, forming the diaphragm and the valve at a depth of 30 $\mu$m on the opposite side of the silicon wafer 31, as shown in figure 5(i). In this way, since the diaphragm 36 is unevenly distributed in the direction of the thickness to the side of the wafer 31 in which the valve 35 is formed, the anisotropic etching for forming the valve is only 30 $\mu$m deep. As a result, there is absolutely no deformation or deficiency of the valve, and an improvement in the sealing performance of the valve is possible. Moreover, in the case of the non-through-hole 34, because the back of the valve is also covered with an oxide layer 32, there is also no deformation of the through-hole, which enhances elimination of bubbles and good liquid flow. After this, the oxide layers 32 and 32a are removed with a hydrofluoric acid solution to form the through-hole 34a and create the condition shown in figure 5(j).

Next, silicon dioxide mask sputtering takes place in order to form a 1 $\mu$m thick pre-load layer 37 on the valve 35 while the substrate is in this condition, as indicated in figure 5(k). This is to prevent the valve 35 from bonding with the glass in the anodic bonding step of the subsequent assembly phase.

After this, thermal oxidation is effected to form over the entire surface of the silicon wafer a 0.13 $\mu$m thick oxidation layer 32, as shown in figure 5(l). This production step, which oxidises the entire surface of the wafer, is effected in order to allow fluids to flow easily and to improve the anti-corrosive properties of the surface of the wafer when the fluids contain chemicals. As shown in figure 5(l), the process for forming the silicon substrate 38, which is used for the body of the micropump and in which the 1 $\mu$m thick pre-load layer 37 is left on the valve 35, is completed.

The silicon substrate 38 produced by this embodiment of the production process is assembled into a micropump in the same manner as described with reference to figures 2 and 3. Therefore, further description will be omitted.

As described above, in this embodiment of the invention for forming the silicon substrate for providing the body of the micropump, lithography and wet anisotropic etching take place twice and the diaphragm is formed with an offset to the side of the wafer having the valve. Therefore, the diaphragm, flow channel and valve resulting from the anisotropic etching have few deformations or deficiencies. As a result, the structure is such that the output from the micropump can be accurately controlled. In addition, the invention provides a micropump that has superior sealing and reverse flow prevention characteristics. Further, the degree of freedom in the design of the micropump is increased, which is advantageous.

Embodiment 2

A number of configurations for applying a pre-load to the valve that makes contact with the surface of the glass substrate in the micropump according to the invention will now be described. These may be employed in the first embodiment described above.

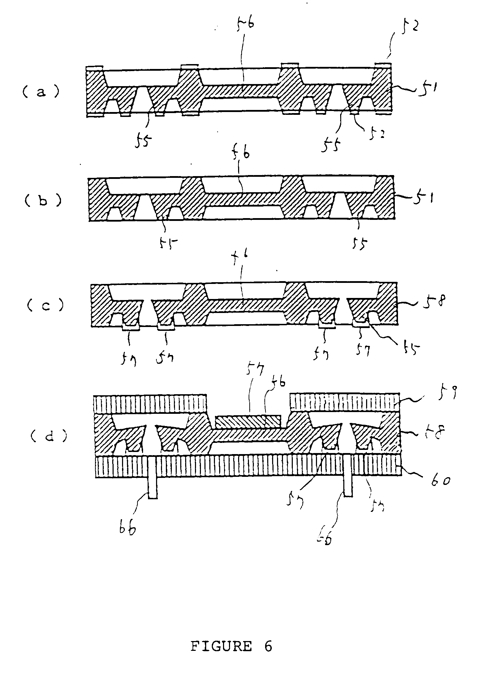

Figure 6 shows the production steps of a process for manufacturing another embodiment of the micropump according to the invention.

Figure 6(a) shows the formation of a valve 55 and a diaphragm 56, by etching both sides of a silicon wafer 51 in a 30% KOH solution heated to 60°C using a thermal oxide layer (silicon oxide layer) 52 as a mask.

The thermal oxide layer 52 used as the mask is removed using hydrofluoric acid as shown in figure 6-(b). After this, a polyimide coating is applied to the top of the valve 55, as indicated in figure 6(c), using a screen printing process. Curing is then effected for 30 minutes at 350°C to form a high polymer layer 57 for providing the pre-load and to complete the silicon substrate 58.

An upper glass substrate 59 and a lower glass substrate 60 are then bonded to each side of the silicon substrate 58 using anodic bonding (350°C, 0.5kV) as indicated in figure 6(d). Finally, a piezoelectric device 57 for driving the diaphragm, and pipes 66 for allowing fluid to flow in and out of the micropump are attached.

The micropump fabricated in this manner was examined as to the stability of the output volume to compare the degree of sealing and the reverse flow conditions with those obtained in the prior art.

In both cases, the micropumps were driven at 60Hz and the output volume was measured. 50% or more of the prior art products examined were rejected because they did not provide the required output volume, which is the rated 2 $\mu$l +/- 0.1 per minute. The valve seals in these instances were insufficient. However, of 50 micropumps manufactured according to the present invention, only one was a reject.

As an alternative to using a polyimide as the high polymer material for the pre-load layer, a polyamide was also tried in the same type of trial. Again, there were no problems in the case of the anodic bonding, and an adequate seal was obtained.

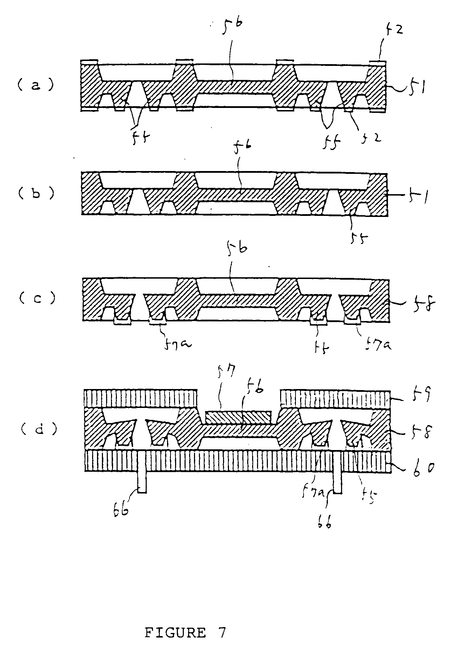

A modification of the process shown in figure 6 is illustrated in figure 7.

The steps represented in figures 7(a), 7(b) and 7(d) are exactly the same as described with reference to figure 6 and, therefore, a further description will be omitted. Referring to figure 7(c), in this step, a partial 0.5 $\mu$m film of TiN is deposited on the upper surface of the valve 55 to form a nitride layer 57a for use as the pre-load layer. This was accomplished by means of ion plating using a metal mask. However, the pre-load layer may also be formed by depositing AlN or TaN in place of the TiN. In the case of an AlN layer, it is desirable to have a film thickness at 1.0 $\mu$m or less. Also, in this case, the anodic bonding conditions may be increased to 400°C and 0.8kV.

In the case of prior art valves in which the pre-load layer comprises a thermal oxide layer with a film thickness of 1.0 $\mu$m or less, it was found on examination that 10% to 20% of the examined valves bonded to the glass substrates. By contrast, almost no such bonding was generated with the valves produced according to the invention.

Further, over a long period of time, it was found that after 1,000 hours had elapsed in a 60°C x 90% RH atmosphere 30% of the examined prior art valves exhibited sticking. However, of 100 micropumps fabricated according to the invention, only 1 displayed a valve sticking problem.

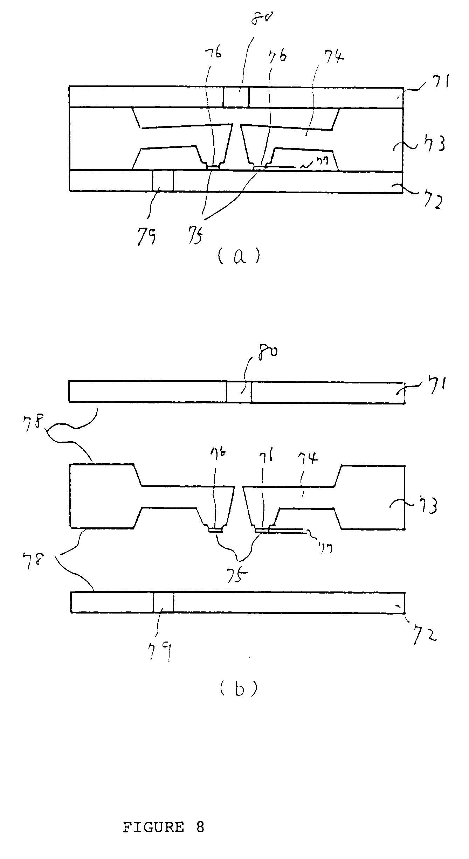

Figure 8 shows a further arrangement, in which a diaphragm 74 having a valve with a pre-load surface level 77 is formed through etching in a 30% KOH solution heated to 60°C. Photolithography and etching were used on both sides of the silicon wafer 73.

The silicon wafer 73 formed with the diaphragm 74 is sandwiched between a bonding surface 78 of a lower glass substrate 72 and a bonding surface 78 of an upper glass substrate 71 and is bonded thereto through anodic bonding. Etching of the silicon wafer 73 is effected using a mask in the form of a 1.5 $\mu$m thermal oxide film. In this structure, the silicon wafer 73 has a valve 76 formed with an annular protrusion 75, which makes contact with the glass substrate 72 and whose width is 200 $\mu$m. The protrusion 75 forms a spacer with a height of 1 $\mu$m to provide the pre-load surface level 77 for shifting the diaphragm 74 of the silicon wafer 73.

The method of fabricating the spacer is to use photolithography to pattern the shape of the circular protrusion 75 on the silicon dioxide film and to etch a 1 $\mu$m thick section of the unnecessary silicon dioxide film (not illustrated). The pre-load surface level 77 can be made higher by continuing to etch the silicon of the silicon wafer 73. The silicon dioxide film may be the leftover mask of thermal oxide film used to etch the silicon wafer 73 or a thermal oxide film that was formed subsequently or a sputtered film. Silicon dioxide formed through thermal CVD has the same effect.

The width and height of the circular protrusion 75 of the valve 76 quite naturally have the optimum dimensions according to the thickness of the diaphragm 74.

Table 1 below shows reverse flow rate results obtained with samples of the present embodiment having various widths and heights for the circular protrusion 75. Table 2 shows a comparison with the prior art. In each case, the diaphragm thickness was 40 $\mu$m and the back pressure was 0.8 m $H_2O$ (7845 Pa).

TABLE 1

| The Embodiment of This Invention in Figure 8 | | |
|---|---|---|
| Contact Flow Width | Height | Reverse Point Volume |
| 50 $\mu$m | 2 $\mu$m | 0.03 $\mu$ l/minute |
| 100 | 2 | 0.02 |
| 200 | 1 | 0.01 |
| 200 | 2 | 0.01 |
| 400 | 4 | 0.04 |

TABLE 2

| Technology of the Prior Art (Comparison) | | |
|---|---|---|
| Contact Flow Width | Height | Reverse Point Volume |
| About 900 $\mu$m | 40 $\mu$m | 0.02 $\mu$ l/minute |

Based on the results in Table 1, the optimal dimensions are 200 $\mu$m for the width of the contact point of the circular protrusion 75 and 1 to 2 $\mu$m for the height of the protrusion.

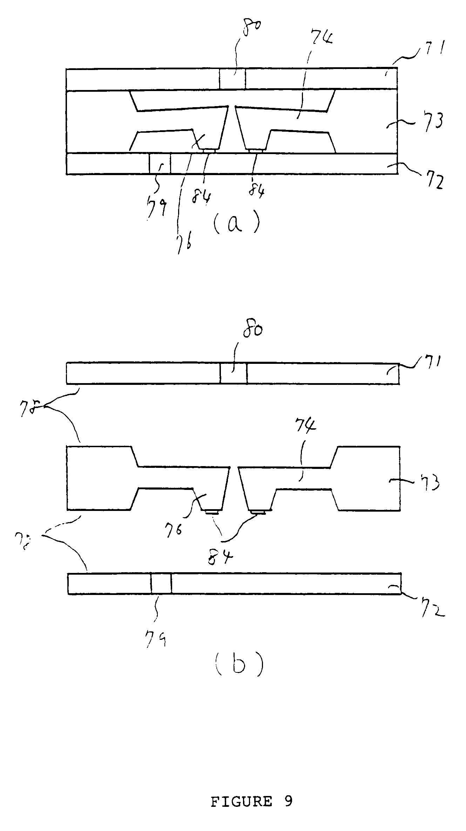

Next, a description will be given of instances when the circular protrusion is formed from other materials, for example high polymer resins such as a polyimide and a polyamide, with reference to figure 9.

In figure 9, the same parts as shown in figure 8 are designated by the same reference numerals and a description thereof will be omitted. The silicon wafer 73 for the pump body is again formed of the same material and as a single unit as in the case of figure 8. The wafer 73 is formed with a valve 76 having thereon a circular protrusion 84.

The method of fabricating the circular protrusion 84 employs photolithography and a high polymer such as a polyimide or a polyamide. In the case of this embodiment, photo-sensitive resins are employed as a pre-polymer material for forming the circular protrusion 84 of a high polymer material. The protrusion 84 is formed with a width of 200 $\mu$m and a height of 2 $\mu$m.

As in the case of the circular protrusion 75, the circular protrusion 84 quite naturally will have the optimum dimensions for the thickness of the diaphragm 74.

Table 3 below shows reverse flow rate results obtained for samples of the embodiment shown in figure 9 having various widths and heights for the circular protrusion 84. Table 4 shows a comparison with the prior art. In each case, the diaphragm thickness was 40 $\mu$m and the back pressure was 0.8 m $H_2O$ (7845 Pa).

## TABLE 3

### The Embodiment of this Invention in Figure 9

| Contact Point Width | Height | Reverse Flow Volume |
|---|---|---|
| 100 μm | 2 μm | 0.04 μ l/minute |
| 200 | 1 | 0.01 |
| 200 | 2 | 0.01 |
| 400 | 2 | 0.01 |
| 500 | 4 | 0.01 |

## TABLE 4

### Technology of the Prior Art (Comparison)

| Contact Point Width | Height | Reverse Flow Volume |
|---|---|---|
| About 900 μm | 40 μm | 0.02 μ l/minute |

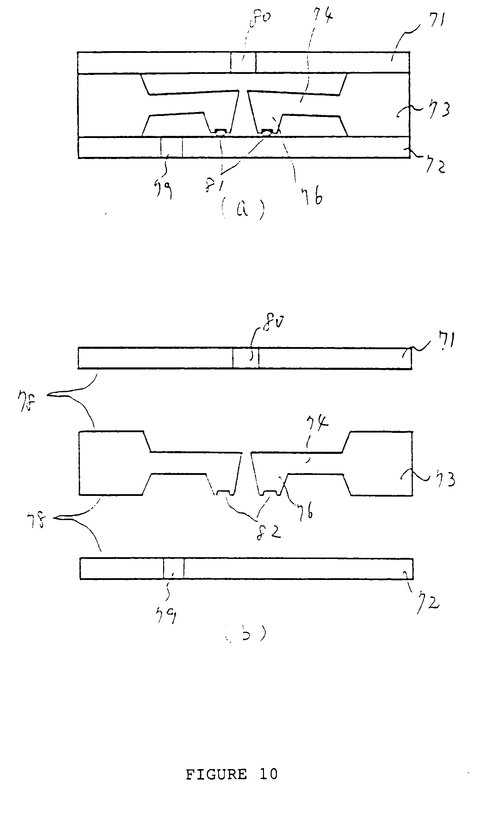

Turning to figure 10, this shows a case in which a circular protrusion 81 is partially buried in the silicon wafer 73 in order to improve the strength of the adhesion of the circular protrusion with the wafer.

The circular protrusion 81 in this instance is fabricated by forming an annular groove 82 concentrically within the valve 76 and inserting a spacer ring within the groove 82. The spacer ring is formed separately from the groove and has a height (axial dimension) greater than the depth of the groove. Alternatively, the spacer ring may be formed on the surface of the wafer 73 using photolithography.

In figure 10, the spacer ring is formed in the wafer 73 with a width of 200 μm and a height of 2 μm using photolithography. Quite naturally, the width and height of the ring have the optimal dimensions for the thickness of the diaphragm 74.

Table 5 shows reverse flow rate results obtained for samples of the diaphragm valve employing the circular protrusion 81 in the form of a spacer ring with various widths and heights. Table 4 again provides a comparison with the prior art. In each case, the diaphragm thickness was 40 μm and the back pressure was 0.8 m $H_2O$ (7845 Pa).

TABLE 5

| The Embodiment of this Invention in Figure 10 | | |
|---|---|---|
| Contact Point Width | Height | Reverse Flow Volume |
| 100 μm | 2 μm | 0.04 μ l/minute |
| 200 | 2 | 0.01 |
| 300 | 3 | 0.01 |
| 500 | 4 | 0.01 |

The arrangements described above for the diaphragm valve make it possible to improve the leakage resistance characteristics of the valve whilst having a stable structure. The circular protrusion can be formed easily and eliminate the non-uniform thickness resulting from mask sputtering, whereby the circular protrusion makes uniform contact with the glass substrate and reverse flow caused by back pressure is prevented.

By employing a flexible high polymer material for the circular protrusion, excellent resistance to leakage is possible even if there is some slight deformation due to the presence of foreign matter.

The strength of the adhesion between the circular protrusion and the silicon wafer is also enhanced if the circular protrusion is in the form of a spacer ring partially buried in the silicon wafer.

Embodiment 3

Features of the invention, which concern the control of the diaphragm and particularly the precision of the micropump fluid displacement volume, will now be described.

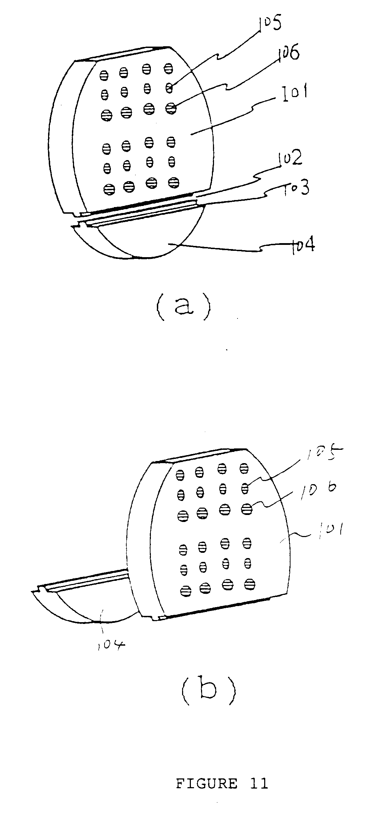

Referring firstly to figure 11, a final part of the production process is illustrated. At the same time that a through-hole 105 is opened in a silicon wafer 101, the wafer 101 is cut at a first etching end point detection pattern 102 and a second etching end point detection pattern 103. Figure 11(a) shows the wafer 101 at the instant that etching has ended. A portion 104 of the silicon wafer is separated by the cutting at the first and second etching end point detection patterns 102 and 103 and is removed to another position, as shown in figure 11(b).

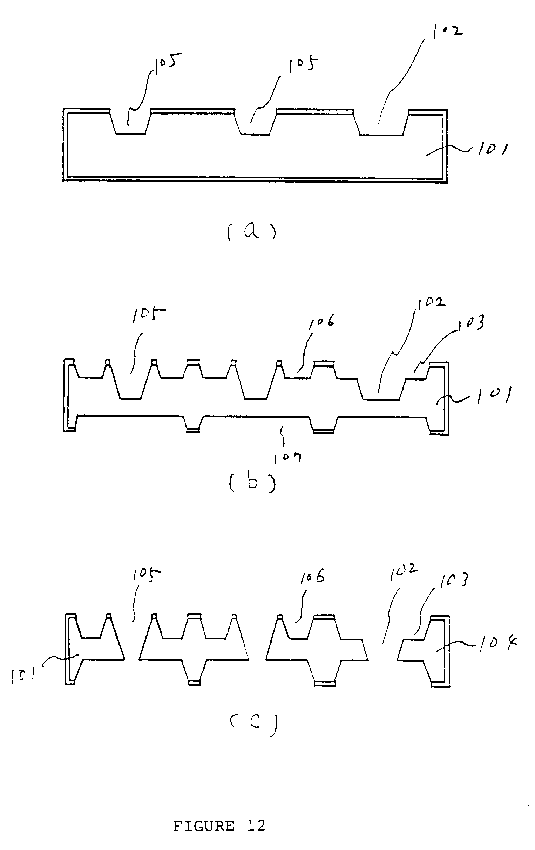

Figure 12 shows the relevant production steps in greater detail. As indicated in figure 12(a), the non-through-hole 105 and the first etching end point detection pattern 102 are initially formed on one side of the silicon wafer 101. The wafer has an external diameter of 3" and a thickness of 220 $\mu$m. Etching is performed in a 30% KOH solution heated to 60°C in order to obtain the desired diaphragm thickness and an accurate etching depth of 40 $\mu$m.

Next, as indicated in figure 12(b), the silicon wafer 101 is etched on both sides. A portion or all of the first etching end point detection pattern 102 and the overlapping second etching end point detection pattern 103 and a valve side diaphragm pattern 106 and a backside diaphragm pattern 107 are etched using the KOH solution.

Then, as indicated in figure 12(c), the through-hole 105 is opened and, at the same time, a hole is opened at the location where the first etching end point detection 102 and the second etching end point detection pattern 103 overlap. This is detected and etching ends. The etching end point in this embodiment is detected visually.

If the thickness of plural silicon wafers 101 is the same, it is sufficient to control one wafer from a batch.

In the prior art, the variation in diaphragm thickness is +/- 5 $\mu$m or more. However, the variation in thickness of diaphragms when the above arrangement is employed is within a range of +/- 1 $\mu$m.

In figure 11, the second etching end point detection pattern is formed on both sides of the silicon wafer. However, if the backside diaphragm pattern 107, which is on the opposite side of the wafer from the valve, is completed first, the same effect may be obtained even if the second etching end point detection pattern is formed only on the side of the wafer where the first etching end point detection pattern is formed, with the second etching end point detection pattern overlapping part or all of the first etching end point detection pattern.

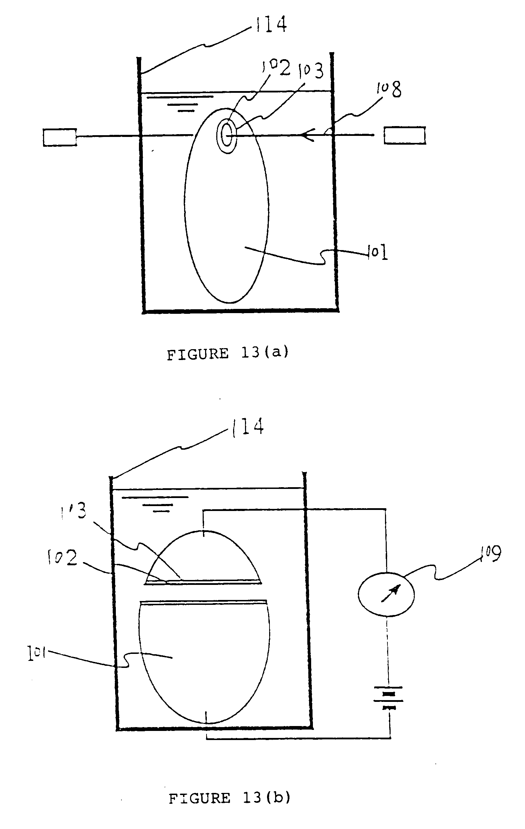

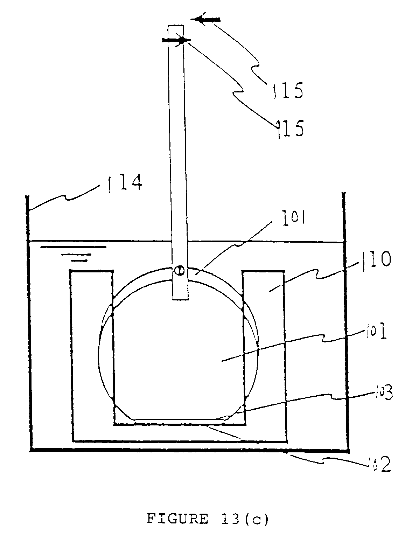

Various arrangements for the etching end point detection pattern, and for detection thereof, will now be described with reference to figure 13. The production of the silicon wafer 101 is the same as in the case of figure 12 and will not be described.

Figure 13(a) shows the use of a laser beam 108, which passes through the first etching end point detection pattern 102 when this has been opened up, for detecting the pattern 102. The wafer 101 is immersed in an etching tank 114, which is transparent and made of thick quartz glass. If the etching tank 114 were made of sapphire, there would be almost no etching in the 30% KOH solution heated to 60°C. Although a laser beam 108 is described, the effect would be the same if other light, for example in the visible spectrum, were used.

In figure 13(b), a current is passed through the silicon wafer 101 and is measured by a current meter 109. At the moment when the through-hole is opened and the wafer 101 is cut, current ceases to flow, and this is detected by the current meter 109.

Still another form of detection is shown in figure 13(c). Again, the silicon wafer 101 is cut at the same time that the through-hole is opened. In this instance, the silicon wafer then drops and the change of position results in movement of a mark 115, which can be detected visually. Alternatively, if the mark 115 is converted to an electrical contact point, the change of position can be detected electrically.

In each of the above instances, if the thickness of a number of silicon wafers 101 is the same, it suffices simply to control one wafer from a batch.

In the prior art, the variation in diaphragm thickness is +/- 5 $\mu$m or more. However, the variation in thickness obtained with the techniques of figure 13 is within a range of +/- 0.8 $\mu$m.

As described above, the thickness of the diaphragm can be controlled accurately by etching to the desired thickness for the diaphragm and by etching the first etching end point detection pattern accurately so that the depth is equal to the thickness of the diaphragm then detecting when the overlapping portion of the first and second etching end point detection patterns opens up. Then, even if there is a variation in the thicknesses of a number of silicon wafers, the diaphragm can be fabricated accurately.

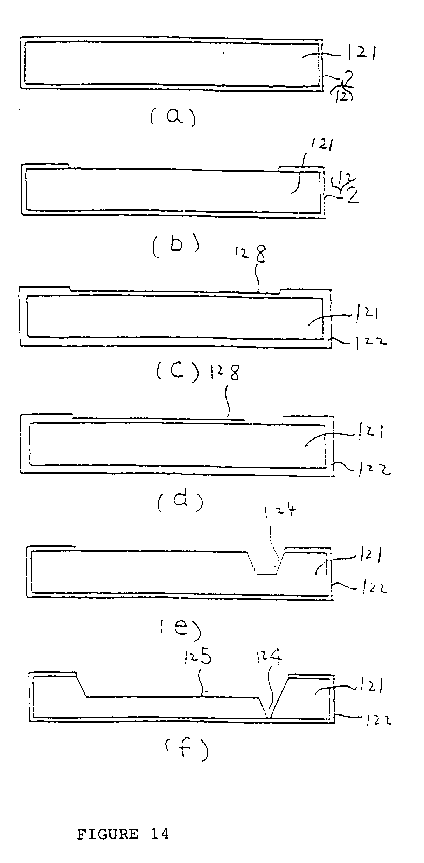

Next, the production of a silicon wafer for use in an ink jet print head will be described as an example of an application of the invention, with reference to figure 14. Referring to figure 14(f), the purpose of the process is to form a flow channel 125 and an ink eject nozzle 124 in the silicon wafer.

Firstly, a silicon substrate 121, which has a (100) crystal surface orientation and which is 200 $\mu$m thick, is heated for 50 minutes at 1,000°C in an oxygen atmosphere that includes steam, to form an oxide layer 122 having a thickness of 0.4 $\mu$m (see figure 14(a)). Pattern processing of the oxide layer 122 is effected by means of photolithography and hydrofluoric acid etching for forming a pattern corresponding to the ink flow channel 125 (see figure 14(b)). Next, the silicon substrate 121 is again heated in an oxygen atmosphere including steam for thermal oxidation. However, the process conditions in this instance are changed to 50 minutes at 900°C. This forms a thermal oxide layer 128 having a thickness of 0.2 $\mu$m in the section correspoding to the ink flow channel 125. The oxide layer in the remaining sections, which was 0.4 $\mu$m thick before this step began, now becomes 0.5 $\mu$m thick (see figure 14(c)).

Next, the patterning process for forming an opening in the thermal oxide layer 128 for the ink eject nozzle 124 is effected using photolithography and hydrofluoric acid etching (see figure 14(d)). An alkaline solution is used to etch the silicon wafer. In this embodiment, a KOH solution is used as the alkaline solution, with a KOH concentration of 25% by weight and a temperature of 80°C. Under these conditions, the silicon etching rate is 1.0 $\mu$m per minute. The thermal oxide layer etching rate is 0.002 $\mu$m per minute.

The silicon substrate 121 is etched for 200 minutes in the aforementioned KOH solution. As a result, the nozzle 124 is opened up to a depth of 200 $\mu$m in the silicon substrate 121. However, 100 minutes after the etching has commenced, the 0.2 $\mu$m thick thermal oxide layer 128, which is equivalent to the ink flow channel 125 disappears, exposing the silicon substrate 121 underneath (see figure 14(e)). Therefore, 100 $\mu$m of this exposed area is etched away on the subsequent 100 minutes of etching (see figure 14(f)). In other words, the nozzle 124 and the ink flow channel 125 of the ink jet print head are formed together in the steps show in figures 14(e) and 14(f).

Since this process does not include photolithography on a deep structure as in the case of the prior art, the patterning process accuracy for the thermal oxide layer, which is the etching mask, is excellent. The desired etching shape for the silicon substrate thus results.

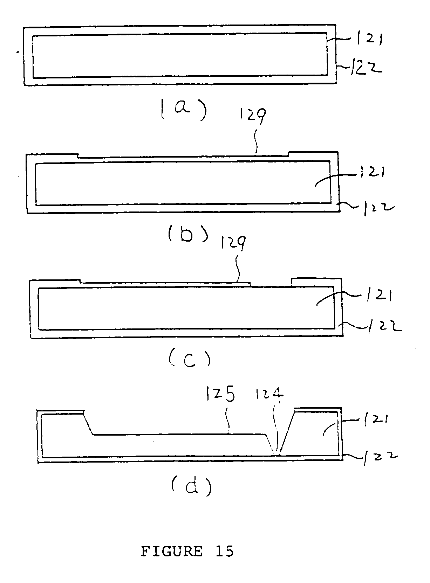

Figure 15 shows a variation of this process for producing an ink jet print head. In this instance, a silicon substrate 121, which has a (100) crystal surface orientation and which is 200 $\mu$m thick, is heated for 70 minutes at 1,000°C in an oxygen atmosphere including steam to form a 0.5 $\mu$m thick oxide layer 122 (see figure 15(a)). The oxide layer 122 undergoes pattern processing by means of photolithography and hydrofluoric acid etching for forming the ink flow channel 125. Here, 0.3 $\mu$m of film is etched away from the oxide layer 122 through half etching, leaving an oxide layer 129 (see figure 15(b)). Next, photolithography is used to form a photo-resist pattern in the shape of the eject nozzle 124 on the oxide layer 129. The oxide layer 129 is then etched using a hydrofluoric acid solution to form an opening (see figure 15(c)). Finally, an alkaline solution is used to etch the silicon substrate 121 in the same manner as described with reference to figure 14 to form the nozzle 124 and the ink flow channel 125.

The process described with reference to figure 15 again avoids the use of photolithography on a deep structure, in contrast to the prior art shown in figure 18. Therefore, the etch shape of the silicon substrate has no defects, allowing a desired, highly accurate shape to be obtained.

The embodiments described with reference to figures 14 and 15 concern the application of the process according to the invention to an ink jet print head. However, the invention is not limited to this. It is also effective in producing various other devices, such as micropumps or pressure sensors, in which alkaline anisotropic etching of a silicon substrate is employed in their production.

## Claims

1. A micropump comprising a silicon substrate (38), which is sandwiched between glass substrates (39,40) and which is formed with a diaphragm (36) and a valve, the valve including a valve membrane (50) and a valve member (35) for controlling fluid flow through a through-hole (34a) in the valve membrane, the valve member engaging one (40) of the glass substrates, characterised in that the diaphragm (36) and the valve membrane (50) are disposed closer to said one glass substrate (40) engaged by the valve member (35) than to the other (39) of the glass substrates.

2. A micropump according to claim 1 characterised in that the valve member (35) has formed thereon a high polymer pre-load layer (57), which contacts said one glass substrate (40).

3. A micropump according to claim 1 characterised in that the valve member (35) has formed thereon a nitride pre-load layer (57), which contacts said one glass substrate (40).

4. A micropump according to claim 1 characterised in that the valve member (35) is provided with an annular protrusion (75,84,81), which contacts said one glass substrate (40).

5. A method of manufacturing a micropump comprising the steps of forming on one side of a silicon substrate (31) a mask pattern of an etch resistant material so as to leave an etching pattern (33c,33d) for providing a diaphragm (36) and a valve membrane (50), forming on the other side of the silicon substrate (31) a mask pattern of an etch resistant material so as to leave an etching pattern (33) for providing a through-hole (34a), forming on said other side a mask pattern of an etch resistant material so as to leave an etching pattern (33a,33b) for providing said diaphragm (36), said valve membrane (50) and a valve member (35), etching the silicon substrate (31) by anisotropic etching to form the diaphragm (36), the valve membrane (50), the valve member (35) and the through hole (34a), and sandwiching the silicon substrate (31) between glass substrates (39,40), characterised in that the etching is effected such that the diaphragm (36) and the valve membrane (50) are closer to said other side than to said one side of the silicon substrate (31).

6. A method according to claim 5 characterised in that the etching comprises a first etching step, in which the silicon substrate (31) is etched on both sides, following forming both the mask pattern on said one side of the silicon substrate (31) for providing the diaphragm (36) and the valve membrane (50) and the mask pattern on said other side of the silicon substrate (31) for providing the through hole (34a), and a second etching step, in which the silicon substrate (31) is etched on both sides, following forming the mask pattern on said other side of the silicon substrate (31) for providing the diaphragm (36), the valve membrane (50) and the valve member (35).

7. A method according to claim 5 characterised in that the etching comprises a first etching step, in which said one side of the silicon substrate (31) is etched, following forming the mask pattern on said one side of the silicon substrate (31) for providing the diaphragm (36) and the valve membrane (50), a second etching step, in which said other side of the silicon substrate (31) is etched, following forming the mask pattern on said other side of the silicon substrate (31) for providing a through-hole (34a), and a third etching step, in which said other side of the silicon substrate (31) is etched, following forming the mask pattern on said other side of the silicon substrate (31) for providing the diaphragm (36), the valve membrane (50) and the valve member (35).

8. A method according to any of claims 5 to 7 characterised by detecting the opening of a passage through the silicon substrate (31) for controlling the duration of the etching.

9. A micropump production method with a structure in which a diaphragm (36), flow channel (41), valve membrane (50), valve member (35) and through-holes (105) are formed on a silicon substrate (101) through wet anisotropic etching and the substrate is sandwiched between glass substrates (39,40), characterised by the formation of a mask pattern on an etch resistant material which has on it an etching pattern that corresponds to aforementioned through-holes (105) and a first etching end point detection pattern (102) and these mask patterns are on one side of the aforementioned silicon substrate (101) and the substrate (101) has a (100) surface orientation, by performing wet anisotropic etching of the aforementioned one side of the silicon substrate (101) so that the depth of the depression that will become the through-hole is the same as the desired thickness of the aforementioned diaphragm, by the formation of a mask pattern of an etch resistant material that corresponds to a second etching end point detection pattern (103) which overlaps at least a portion of the mask pattern of the etch resistant material of the aforementioned first etching end point detection pattern (102) and is at least on one side of the aforementioned silicon substrate (101), and by the etching of the aforementioned silicon substrate (101) and then ending that etching by detecting that the overlapping portion of the mask pattern of the etch resistant material for the first and the second etching end point detection patterns (102,103) has opened.

10. A micropump production method that uses as a component a silicon substrate (121) that has been processed by means of wet anisotropic etching to form grooves (125) and through-holes (124), characterised by forming a silicon dioxide layer (122) with areas of varying thicknesses on the aforementioned silicon substrate (121) as an etching mask, by gradually eliminating the thinner areas of the aforementioned silicon dioxide layer (122) during the etching of the silicon substrate (121) in the order of the thickness of the silicon dioxide layer (122) and by continuing to etch the silicon below the aforementioned silicon dioxide layer (122) that has been etched away and forming a number of depression areas of different depths in the aforementioned silicon substrate (121).

**Patentansprüche**

1. Mikropumpe, umfassend ein Siliziumsubstrat (38), welches sandwichartig zwischen Glassubstraten (39, 40) angeordnet ist, und welches mit einer Membran (36) und einem Ventil ausgebildet ist, wobei das Ventil eine Ventilmembran (50) und ein Ventilelement (35) zum Steuern des Fluidflusses durch eine Durchgangsöffnung (34a) in der Ventilmembran umfaßt, wobei das Ventil an einem (40) der Glassubstrate angreift,
   dadurch gekennzeichnet,
   daß die Membran (36) und die Ventilmembran (50) näher an dem einen Glassubstrat (40), an welchem das Ventilelement (35) angreift, angeordnet sind, als an dem anderen (39) der Glassubstrate.

2. Mikropumpe nach Anspruch 1,
   dadurch gekennzeichnet,
   daß auf dem Ventilelement (35) eine hochpolymere Vorlastschicht (57) gebildet ist, welche das eine Glassubstrat (40) berührt.

3. Mikropumpe nach Anspruch 1,
   dadurch gekennzeichnet,
   daß auf dem Ventilelement (35) eine Nitrid-Vorlastschicht (57) gebildet ist, welche das eine Glassubstrat (40) berührt.

4. Mikropumpe nach Anspruch 1,
   dadurch gekennzeichnet,
   daß das Ventilelement (35) mit einem ringförmigen Vorsprung (75, 84, 81) versehen ist, welcher das eine Glassubstrat (40) berührt.

5. Verfahren zur Herstellung einer Mikropumpe, umfassend die Schritte: Bilden eines Maskenmusters aus ätzresistentem Material auf einer Seite eines Siliziumsubstrats (31), um ein Ätzmuster (33c, 33d) zum Vorsehen einer Membran (36) und einer Ventilmembran (50) zu lassen, Bilden eines Maskenmusters aus ätzresistentem Material auf der anderen Seite des Siliziumsubstrats (31), um ein Ätzmuster (33) zum Vorsehen eines Durchgangslochs (34a) zu lassen, Bilden eines Maskenmusters aus ätzresistentem Material auf der anderen Seite, um ein Ätzmuster (33a, 33b) zum Vorsehen der Membran (36), der Ventilmembran (50) und eines Ventilelements (35) zu lassen, Ätzen des Siliziumsubstrats (31) durch anisotropes Ätzen, um die Membran (36), die Ventilmembran (50), das Ventilelement (35) und das Durchgangsloch (34a) zu bilden, und sandwichartiges Anordnen des Siliziumsubstrats (31) zwischen den Glassubstraten (39, 40),
   dadurch gekennzeichnet,
   daß das Ätzen derart durchgeführt wird, daß die Membran (36) und die Ventilmembran (50) näher an der anderen Seite als an der einen Seite des Siliziumsubstrats (31) liegen.

6. Verfahren nach Anspruch 5,
   dadurch gekennzeichnet,
   daß das Ätzen einen ersten Ätzschritt umfaßt, in welchem das Siliziumsubstrat (31) an beiden Seiten geätzt wird, nachdem sowohl das Maskenmuster auf der einen Seite des Siliziumsubstrats (31) zum Vorsehen der Membran (36) und der Ventilmembran (50) als auch das Maskenmuster auf der anderen Seite des Siliziumsubstrats (31) zum Vorsehen des Durchgangslochs (34a) gebildet worden sind, sowie

EP 0 465 229 B1

einen zweiten Ätzschritt, in welchem das Silizium (31) auf beiden Seiten geätzt wird, nachdem das Maskenmuster auf der anderen Seite des Siliziumsubstrats (31) zum Vorsehen der Membran (36), der Ventilmembran (50) und des Ventilelements (35) gebildet worden ist.

7. Verfahren nach Anspruch 5,
dadurch gekennzeichnet,
daß das Ätzen eines ersten Ätzschritt umfaßt, in welchem die eine Seite des Siliziumsubstrats (31) geätzt wird, nachdem das Maskenmuster auf der einen Seite des Siliziumsubstrats (31) zum Vorsehen der Membran (36) und der Ventilmembran (50) gebildet worden ist, sowie einen zweiten Schritt, in welchem die andere Seite des Siliziumsubstrats (31) geätzt wird, nachdem das Maskenmuster auf der anderen Seite des Siliziumsubstrats (31) zum Vorsehen eines Durchgangslochs (34a) gebildet worden ist, und einen dritten Ätzschritt, in welchem die andere Seite des Siliziumsubstrats (31) geätzt wird, nachdem das Maskenmuster auf der anderen Seite des Siliziumsubstrats (31) zum Vorsehen der Membran (36), der Ventilmembran (50) und des Ventilelements (35) gebildet worden ist.

8. Verfahren nach einem der Ansprüche 5 bis 7,
gekennzeichnet durch
das Erfassen des Öffnens eines Durchgangs durch das Siliziumsubstrat (31) zum Steuern der Ätzdauer.

9. Mikropumpenherstellungsverfahren mit einer Struktur, in welcher eine Membran (36), ein Flußkanal (41), eine Ventilmembran (50), ein Ventilelement (35) und Durchgangslöcher (105) auf einem Siliziumsubstrat (101) durch nasses anisotropes Ätzen gebildet werden und das Substrat sandwichartig zwischen Glassubstraten (39, 40) angeordnet wird,
gekennzeichnet
durch das Bilden eines Maskenmusters aus ätzresistentem Material, welches ein Ätzmuster aufweist, das den vorher erwähnten Durchgangslöchern (105) entspricht, sowie ein erstes Ätzendpunkterfassungsmuster (102), wobei diese Maskenmuster auf einer Seite des vorher erwähnten Siliziumsubstrats (101) angeordnet sind, und wobei das Substrat (101) eine (100)-Oberflächenorientierung aufweist, durch das Durchführen eines nassen anisotropen Ätzens der vorher erwähnten einen Seite des Siliziumsubstrats (101) derart, daß die Tiefe der Einsenkung, welche das Durchgangsloch wird, die gleiche ist, wie die gewünschte Dicke der vorher erwähnten Membran, durch das Bilden eines Maskenmusters aus ätzresistentem Material, welches einem zweiten Ätzendpunkterfassungsmuster (103) entspricht, das wenigstens einen Abschnitt des Maskenmusters des ätzresistenten Materials des vorher erwähnten ersten Ätzendpunkterfassungsmusters (102) überlappt und wenigstens auf einer Seite des vorher erwähnten Siliziumsubstrats (101) angeordnet ist, und durch Ätzen des vorher erwähnten Siliziumsubstrats (101) und dann Beenden des Ätzens durch Erfassen, daß der sich überlappende Abschnitt des Maskenmusters des ätzresistenten Materials für das erste und das zweite Ätzendpunkterfassungsmuster (102, 103) sich geöffnet hat.

10. Mikropumpen-Herstellungsverfahren, welches als eine Komponente ein Siliziumsubstrat (121) verwendet, welches vermittels eines nassen anisotropen Ätzens zum Bilden von Vertiefungen (125) und Durchgangslöchern (124) bearbeitet worden ist,
gekennzeichnet
durch das Bilden einer Siliziumdioxidschicht (122) mit Bereichen variierender Dicken auf dem vorher erwähnten Siliziumsubstrat 121 als Ätzmaske, durch allmähliches Beseitigen der dünneren Bereiche der vorher erwähnten Siliziumdioxidschicht (122) während des Ätzens des Siliziumsubstrats (121) in der Größenordnung der Dicke der Siliziumdioxidschicht (122) und durch das Fortsetzen des Ätzens des Silizium unter der vorher erwähnten Siliziumdioxidschicht (122), welche weggeätzt worden ist, und Bilden einer Anzahl von Einsenkungsbereichen mit verschiedenen Tiefen in dem vorher erwähnten Siliziumsubstrat (121).

**Revendications**

1. Micro-pompe comprenant un substrat en silicium (38) qui est intercalé entre des substrats en verre (39, 40) et qui est formé avec un diaphragme (36) et une valve, la valve comprenant une membrane de valve (50) et un élément de valve (35) pour commander un écoulement de fluide à travers un trou traversant (34a) dans la membrane de valve, l'élément de valve se mettant en prise avec l'un (40) des substrats en verre, caractérisée en ce que le diaphragme (36) et la membrane de valve (50) sont disposés plus près dudit substrat en verre (40) en prise avec l'élément de valve (35) que de l'autre (39) des substrats en verre.

2. Micro-pompe selon la revendication 1, caractérisée en ce que l'élément de valve (35) a, formée sur lui, une couche de précharge en polymère à poids moléculaire élevé (57) qui est au contact dudit substrat en verre (40).

3. Micro-pompe selon la revendication 1, caractérisée en ce que l'élément de valve (35) a, formée sur lui, une couche de précharge en nitrure (57) qui est au contact dudit substrat en verre (40).

4. Micro-pompe selon la revendication 1, caractérisée en ce que l'élément de valve (35) est muni d'une saillie annulaire (75, 84, 81) qui est au contact dudit substrat en verre (40).

5. Procédé de fabrication d'une micro-pompe, comprenant les étapes consistant à former sur une face d'un substrat en silicium (31) un motif de masquage dans un matériau résistant à la gravure, de manière à laisser un motif de gravure (33c, 33d) pour fournir un diaphragme (36) et une membrane de valve (50), à former sur l'autre face du substrat en silicium (31) un motif de masquage dans un matériau résistant à la gravure, de manière à laisser un motif de gravure (33) pour fournir un trou traversant (34a), à former sur ladite autre face un motif de masquage dans un matériau résistant à la gravure, de manière à laisser un motif de gravure (33a, 33b) pour fournir ledit diaphragme (36), ladite membrane de valve (50) et un élément de valve (35), à graver le substrat en silicium (31) par gravure anisotrope pour former le diaphragme (36), la membrane de, valve (50), l'élément de valve (35) et le trou traversant (34a), et à prendre en sandwich le substrat en silicium (31) entre des substrats en verre (39, 40), caractérisé en ce que la gravure est effectuée de telle manière que le diaphragme (36) et la membrane de valve (50) sont plus proches de ladite autre face que de ladite première face du substrat en silicium (31).

6. Procédé selon la revendication 5, caractérisé en ce que la gravure comprend une première étape de gravure, dans laquelle le substrat en silicium (31) est gravé sur les deux faces, après avoir formé à la fois le motif de masquage sur ladite première face du substrat en silicium (31) pour fournir le diaphragme (36) et la membrane de valve (50) et le motif de masquage sur ladite autre face du substrat en silicium (31) pour former le trou traversant (34a), et une deuxième étape de gravure, dans laquelle le substrat en silicium (31) est gravé sur ses deux faces, après avoir formé le motif de masquage sur ladite autre face du substrat en silicium (31) pour fournir le diaphragme (36), la membrane de valve (50) et l'élément de valve (35).

7. Procédé selon la revendication 5, caractérisé en ce que la gravure comprend une première étape de gravure, dans laquelle ladite première face du substrat en silicium (31) est gravée, après avoir formé le motif de masquage sur ladite première face du substrat en silicium (31) pour fournir le diaphragme (36) et la membrane de valve (50), une deuxième étape de gravure, dans laquelle ladite autre face du substrat en silicium (31) est gravée, après avoir formé le motif de masquage sur ladite autre face du substrat en silicium (31) pour former un trou traversant (34a), et une troisième étape de gravure, dans laquelle ladite autre face du substrat en silicium (31) est gravée, après avoir formé le motif de masquage sur ladite autre face du substrat en silicium (31) pour fournir le diaphragme (36), la membrane de valve (50) et l'élément de valve (35).

8. Procédé selon l'une quelconque des revendications 5 à 7, caractérisé par le fait de détecter l'ouverture d'un passage à travers le substrat en silicium (31) pour commander la durée de la gravure.

9. Procédé de fabrication d'une micro-pompe avec une structure dans laquelle un diaphragme (36), un canal d'écoulement (41), une membrane de valve (50) un élément de valve (35) et des trous traversants (105) sont formés sur un substrat en silicium (101) par gravure anisotrope humide, et le substrat est pris en sandwich entre des substrats en verre (39, 40), caractérisé par la formation d'un motif de masquage en matériau résistant à la gravure qui a sur lui un motif de gravure qui correspond aux trous traversants susmentionnés (105) et un premier motif de détection de point de fin de gravure (102) et ces motifs de masquage sont sur une face du substrat en silicium (101) susmentionné et le substrat (101) a une orientation de surface (100), en effectuant une gravure anisotrope humide de ladite première face du substrat en silicium (101) de sorte que la profondeur de la cavité qui deviendra le trou

19

traversant est la même que l'épaisseur désirée dudit diaphragme, par la formation d'un motif de masquage en matériau résistant à la gravure qui correspond à un deuxième motif de détection de point de fin de gravure (103) qui recouvre au moins une partie du motif de masquage en matériau résistant à la gravure dudit premier motif de détection de point de fin de gravure (102) et est au moins sur une face dudit substrat en silicium (101), et par la gravure dudit substrat en silicium (101), et ensuite achèvement de la gravure en détectant que la partie en recouvrement du motif de masquage en matériau résistant à la gravure des premier et deuxième motifs de détection de point de fin de gravure (102, 103) s'est ouverte.

10. Procédé de fabrication d'une micro-pompe qui utilise en tant que composant un substrat en silicium (121) qui a été traité au moyen d'une gravure anisotrope humide pour former des gorges (125) et des trous traversants (124), caractérisé en ce qu'il consiste à former une couche de dioxyde de silicium (122) avec des zones d'épaisseurs variables sur ledit substrat en silicium (121) en tant que masque de gravure, à éliminer progressivement les zones plus minces de la dite couche de dioxyde de silicium (122) au cours de la gravure du substrat en silicium (121) de l'ordre de l'épaisseur de la couche de dioxyde de silicium (122), et de continuer à graver le silicium au-dessus de ladite couche de dioxyde de silicium (122) qui a été éliminée par gravure et à former un nombre de zones en renfoncement de différentes profondeurs dans ledit substrat en silicium (121).

FIGURE 1(a)

FIGURE 1(b)

FIGURE 1(c)

FIGURE 1(d)

FIGURE 1(e)

FIGURE 1(f)

FIGURE 1(g)

修正
Correction

FIGURE 1(h)

FIGURE 1(i)

修正
Correction

FIGURE 2

FIGURE 3

FIGURE 4(a)

FIGURE 4(b)

FIGURE 4(c)

FIGURE 4(d)

FIGURE 4(e)

FIGURE 4(f)

32   36a  32   36b      36a
31
32
32a   33b  32a34  33a

FIGURE 4(g)

32        32      36 31   34a
31
32
32a      35    32a

FIGURE 4(h)

31        36    31  34a
31
35        35

FIGURE 4(i)

27

FIGURE 4(j)

FIGURE 4(k)

FIGURE 5(a)

FIGURE 5(b)

FIGURE 5(c)

FIGURE 5(d)

FIGURE 5(e)

FIGURE 5(f)

FIGURE 5(g)

FIGURE 5(h)

FIGURE 5(i)

FIGURE 5(j)

FIGURE 5(k)

FIGURE 5(1)

FIGURE 6

FIGURE 7

FIGURE 8

FIGURE 9

FIGURE 10

(a)

(b)

FIGURE 11

( a )

( b )

( c )

FIGURE 12

FIGURE 13(a)

FIGURE 13(b)

FIGURE 13(c)

(a)

(b)

(c)

(d)

(e)

(f)

FIGURE 14

FIGURE 15

FIGURE 16

FIGURE 17

44

a

b

c

d

e

f

FIGURE 18